# EUROPÄISCHE PATENTSCHRIFT

(11) **EP 3 641 064 B1**
(45) Veröffentlichungstag und Bekanntmachung des Hinweises auf die Patenterteilung: **24.01.2024**
(21) Anmeldenummer: 19202320.8
(22) Anmeldetag: 09.10.2019
(51) Int. Cl.: H01R 11/28, H01R 43/16

(54) **VERFAHREN ZUR HERSTELLUNG EINER BATTERIEPOLKLEMME, BATTERIEPOLKLEMME UND BATTERIESENSOR**
METHOD OF MANUFACTURING A BATTERY TERMINAL, BATTERY TERMINAL AND BATTERY SENSOR
PROCÉDÉ DE FABRICATION D'UNE BORNE POLAIRE DE BATTERIE, BORNE POLAIRE DE BATTERIE ET CAPTEUR DE BATTERIE

(30) Priorität: 15.10.2018 DE 102018217604
(43) Veröffentlichungstag der Anmeldung: 22.04.2020
(73) Patentinhaber: Continental Automotive Technologies GmbH, 30165 Hannover (DE)
(72) Erfinder: Sammereier, Dennis - c/o Continental Teves AG & Co. OHG, 60488 Frankfurt am Main (DE)
(74) Vertreter: Continental Corporation

(56) Entgegenhaltungen:
- EP-A1- 2 192 656
- WO-A1-2012/067251
- DE-U1- 7 933 001
- US-A1- 2018 076 436

## Beschreibung

Die Erfindung betrifft ein Verfahren zur Herstellung einer Batteriepolklemme sowie eine mit diesem Verfahren hergestellte Batteriepolklemme und einen Batteriesensor.

Batteriesensoren werden in Fahrzeugen eingesetzt, um Informationen über den Batteriezustand, beispielsweise den Ladezustand der Batterie, zu erhalten. Der Batteriesensor ist üblicherweise an einem der Batteriepole der Fahrzeugbatterie, insbesondere am Minuspol der Batterie, befestigt. Der Batteriesensor hat hierzu üblicherweise eine Batteriepolklemme, die auf den Batteriepol aufgesteckt und an diesem verklemmt wird, beispielsweise, indem über ein Spannmittel der Durchmesser einer Aufnahme für den Batteriepol reduziert wird.

Die Batteriepolklemme muss einen zuverlässigen Halt des Batteriesensors an der Fahrzeugbatterie sicherstellen, um eine zuverlässige Stromversorgung der Verbraucher im Fahrzeug sowie eine zuverlässige Messung des Batteriezustandes sicherzustellen.

Darüber hinaus soll der Batteriesensor, also auch die Batteriepolklemme, einfach und kostengünstig hergestellt werden können.

Beispielsweise werden die Batteriepolklemmen durch Biegeprozesse oder Tiefziehprozesse hergestellt. Beispiele für solche Batteriepolklemmen finden sich beispielsweise in der WO 2012067251 A1, der US 2018076436 A1, der EP 2 192 656 A1 oder der DE 79 33 001 U1.

Aufgabe der Erfindung ist es, ein Verfahren zur Herstellung einer Batteriepolklemme bereitzustellen, das eine einfache und kostengünstige Herstellung einer Batteriepolklemme ermöglicht. Aufgabe der Erfindung ist es des Weiteren eine kostengünstige und einfach herzustellende Batteriepolklemme bereitzustellen, die einen ausreichend stabilen Halt an einem Batteriepol einer Fahrzeugbatterie bereitstellt. Aufgabe der Erfindung ist es des Weiteren, einen Batteriesensor mit einer solchen Batteriepolklemme bereitzustellen.

Zur Lösung der Aufgabe ist ein Verfahren zur Herstellung einer Batteriepolklemme, insbesondere für eine Fahrzeugbatterie in einem Fahrzeug, vorgesehen. Die Batteriepolklemme weist einen Grundkörper auf, mit einem Klemmabschnitt für einen Batteriepol einer Batterie, insbesondere einer Fahrzeugbatterie, und am Klemmabschnitt vorgesehenen Aufnahmen für ein Spannmittel. Der Klemmabschnitt umschließt einen, insbesondere im Wesentlichen zylindrischen, Aufnahmeraum für den Batteriepol der Batterie in Umfangsrichtung zumindest abschnittsweise und weist in Umfangsrichtung eine Unterbrechung mit einander zugewandten Rändern auf, wobei die Aufnahmen für das Spannmittel an den Rändern des Klemmabschnitts vorgesehen sind. Das Verfahren weist die folgenden Schritte auf:
- Bereitstellen eines ebenen Grundkörpers,
- Ausformen des Klemmabschnitts durch ein Tiefzugverfahren, und
- Ausformen der Aufnahmen durch einen Umformprozess, wobei die Aufnahmen jeweils durch Umbiegen eines Abschnitts des Grundkörpers und anschließendes Verstemmen eines am Abschnitt vorgesehenen Vorsprungs in einer Aussparung des Grundkörpers hergestellt werden, so dass die Aufnahmen jeweils einen Kanal für das Spannmittel bilden, der in einer Umfangsrichtung geschlossen ist, wobei die Längsachsen de Kanäle der aufnahmen auf einer gemeinsamen Geraden liegen.

Des Weiteren ist zur Lösung der Aufgabe eine Batteriepolklemme vorgesehen, insbesondere für eine Fahrzeugbatterie in einem Fahrzeug, wobei die Batteriepolklemme einen Grundkörper aufweist, mit einem Klemmabschnitt für einen Batteriepol einer Batterie, insbesondere einer Fahrzeugbatterie, und am Klemmabschnitt vorgesehenen Aufnahmen für ein Spannmittel. Der Klemmabschnitt umschließt einen, insbesondere im Wesentlichen zylindrischen, Aufnahmeraum für den Batteriepol der Batterie in Umfangsrichtung zumindest abschnittsweise und weist in Umfangsrichtung eine Unterbrechung mit einander zugewandten Rändern auf, wobei die Aufnahmen für das Spannmittel an den Rändern des Klemmabschnitts vorgesehen sind. Der Grundkörper ist einstückig ausgebildet, wobei der Klemmabschnitt mit einem Tiefzugverfahren aus dem Grundkörper hergestellt ist und die Aufnahmen durch Umformen des Grundkörpers hergestellt sind. Die Aufnahmen werden durch Umbiegen eines Abschnitts des Grundkörpers und anschließendes Verstemmen eines am Abschnitt vorgesehenen Vorsprungs in einer Aussparung des Grundkörpers hergestellt, so dass die Aufnahmen jeweils einen in Umfangsrichtung geschlossenen Kanal für das Spannmittel bilden, wobei die Längsachsen der Kanäle auf einer gemeinsamen Geraden liegen.

Vorzugsweise wird der Grundkörper als ebenes Bauteil, insbesondere als ebenes Blechbauteil, bereitgestellt, aus dem der Klemmabschnitt sowie die Aufnahmen geformt werden. Der Klemmabschnitt kann durch ein Tiefzugverfahren auf einfache Weise hergestellt werden. Insbesondere ist durch ein Tiefzugverfahren eine einfache Herstellung eines im wesentlichen zylindrischen Aufnahmeraums möglich. Der Aufnahmeraum kann auch leicht komisch ausgebildet sein bzw. sich an einem Einschubende für den Batteriepolen konisch aufweiten, sodass ein leichteres Aufschieben auf den Batteriepol möglich ist. Ebenso ist durch den Umformprozess eine einfache Herstellung der Aufnahmen für das Spannmittel möglich. Insbesondere ist eine einfache Anpassung der Aufnahmen an das Spannmittel möglich. Durch das Tiefzugverfahren sowie den Umformprozess ist insgesamt eine einfache und schnelle Herstellung einer Batteriepolklemme möglich.

Der Abschnitt des Grundkörpers weist hierzu vorzugsweise einen Vorsprung auf und am Grundkörper ist eine Aussparung vorgesehen, in die sich der Vorsprung nach dem Umbiegen hinein erstreckt. Der Vorsprung ist nach dem Umbiegen insbesondere in der Aussparung verstemmt. Die Aufnahme kann durch Umbiegen auf einfache Weise hergestellt werden. Durch das anschließende Verstemmen ist zudem eine Verformung der Aufnahme auch bei hohen Kräften, zuverlässig verhindert.

Zumindest eine Aufnahme kann einen Kanal aufweisen, der durch Umbiegen eines Abschnitts des Grundkörpers hergestellt sind.

Das Spannmittel weist beispielsweise ein Spannelement und einen Gegenhalter auf, die sich jeweils an einer der Aufnahmen abstützen. Der Gegenhalter kann relativ zum Spannelement verschoben werden, wodurch die Aufnahmen aufeinander zu bewegt bzw. gedrängt werden. Dadurch wird der Durchmesser der Aufnahme verringert, sodass sich die Batteriepolklemme am Batteriepol verklemmen kann und somit sicher gehalten ist. Das Spannelement ist beispielsweise eine Schraube und der Gegenhalter weist ein zur Schraube korrespondierendes Innengewinde auf. Die Schraube kann sich hierbei durch einen Kanal der Aufnahme erstrecken und sich mit dem Schraubenkopf an der Aufnahme abstützen. Der Gegenhalter kann beispielsweise durch die zweite Aufnahme gebildet sein, in der ein Innengewinde ausgebildet ist. Vorzugsweise ist der Gegenhalter aber eine Mutter, die sich an der zugeordneten Aufnahme abstützt.

Vorzugsweise können auch beide Aufnahmen jeweils durch einen Kanal gebildet sein, wobei die Längsachsen im Wesentlichen auf einer gemeinsamen Geraden verlaufen. Die Gerade verläuft insbesondere in einer senkrecht zur Längsachse des Aufnahmeraums angeordneten Ebene und/oder senkrecht zur Längsachse des Aufnahmeraums.

Die Schraube kann sich durch beide Aufnahmen erstrecken, wobei sich die Schraube mit dem Schraubenkopf und die Mutter an einander abgewandten Abstützflächen der beiden Aufnahmen abstützen. In dieser Ausführungsform sind beide Aufnahmen durch Kanäle ausgebildet, die im Wesentlichen auf einer gemeinsamen Geraden liegen. Vorzugsweise verläuft diese Gerade in eine senkrecht zur Achse der Polaufnahme angeordneten Ebene und/oder senkrecht zur Achse der Polaufnahme.

An zumindest einer Aufnahme kann eine Verdrehsicherung, eine Verschiebesicherung und/oder eine Verliersicherung für das Spannmittel durch einen Umformprozess hergestellt werden.

An zumindest einer Aufnahme kann somit eine Verdrehsicherung für das Spannmittel vorgesehen sein, wobei die Verdrehsicherung eine Drehung des Spannmittels um die Längsachse der Aufnahme verhindert. Insbesondere ist die Verdrehsicherung durch einen Umformprozess hergestellt. Vorzugsweise wird eine Lasche oder ein Vorsprung des Grundkörpers so umgebogen, dass dieser eine Drehung des Spannmittels oder eines Teils des Spannmittels verhindert. Beispielsweise weist das Spannmittel eine Schraube und einen Gegenhalter mit einem zur Schraube korrespondierenden Innengewinde auf. Die Verdrehsicherung greift am Gegenhalter oder der Schraube an, sodass der Gegenhalter oder die Schraube gegen ein Verdrehen gesichert ist. Wird das frei drehbare Element des Klemmelements, also die Schraube oder der Gegenhalter gedreht, werden somit die beiden Elemente des Klemmelements gegeneinander verdreht und somit ineinander eingeschraubt, sodass die Ränder der Polaufnahme aufeinander zu bewegt werden und der Batteriepol geklemmt werden kann. Durch die Verdrehsicherung ist also eine Montage der Batteriepolklemme mit einem einzigen Werkzeug möglich. Da die Verdrehsicherung aus einem Abschnitt des Grundkörpers herausgeformt wird, ist eine einfache Herstellung der Verdrehsicherung und der gesamten Batteriepolklemme möglich.

An zumindest einer Aufnahme kann zudem eine Verschiebesicherung für das Spannmittel vorgesehen sein, die ein Verschieben des Spannmittels in Richtung der Längsachse verhindert, wobei die Verschiebesicherung insbesondere durch einen Umformprozess hergestellt ist. Die Verschiebesicherung hält das Spannmittel, beispielsweise die Schraube und/oder den Gegenhalter, zuverlässig an der jeweiligen Aufnahme. Werden die Schraube und der Gegenhalter auseinander gedreht, beispielsweise um die Verklemmung der Batteriepolklemme am Batteriepol zu lösen, werden die Aufnahmen, die in der Verschieberichtung mit der Schraube und/dem Gegenhalter gekoppelt sind, mit der Schraube und den Gegenhalter auseinander bewegt. Dadurch erfolgt bei einem Entspannen des Spannmittels, also beispielsweise einem Auseinanderdrehen der Schraube und des Gegenhalter auch zwangsweise eine Aufweitung der Polaufnahme, sodass ein einfaches Abziehen der Batteriepolklemme vom Batteriepool möglich ist. Die Verschiebesicherung ermöglicht somit eine Zwangsöffnung der Batteriepolklemme durch das Zusammenwirken des Spannmittels mit den Aufnahmen. Da die Verschiebesicherung durch einen Abschnitt des Grundkörpers hergestellt wird, sind keine zusätzlichen Montage- und/oder Fügeschritte erforderlich.

Des Weiteren kann an zumindest einer Aufnahme eine Verliersicherung vorgesehen sein, die das Spannmittel an der Aufnahme fixiert, wobei die Verlierersicherung insbesondere durch einen Umformprozess hergestellt ist. Die Verliersicherung verhindert, beispielsweise in unmontierten Zustand der Batteriepolklemme, dass das Spannmittel oder Teile des Spannmittels verloren gehen können. Auch die Verschiebesicherung kann durch den Umformprozess auf einfache Weise ohne zusätzliche Montage- und/oder Fügeschritte hergestellt werden. Die Verliersicherung, die Verdrehsicherung sowie die Verschiebesicherung können gemeinsam, insbesondere aus einem oder mehreren Abschnitten des Grundkörpers ausgebildet sein
Vor dem Ausbilden einer Verdrehsicherung, einer Verschiebesicherung und/oder einer Verliersicherung wird vorzugsweise ein Spannmittel in die Aufnahmen eingesetzt. Anschließend können die Verdrehsicherung, die Verschiebesicherung und/oder die Verliersicherung durch Umbiegen oder umformen eines Abschnitts so hergestellt werden, dass das Spannmittel verdrehsicher, verschiebesicher oder verliersicher an der der jeweiligen Aufnahme gehalten ist. Das nachträgliche Umformen hat den Vorteil, dass eine besonders zuverlässige Sicherung hergestellt werden kann. Des Weiteren ist eine einfache Montage des Spannmittels möglich, da die Verdrehsicherung, die Verschiebesicherung und/oder die Verliersicherung noch nicht hergestellt bzw. ausgeformt sind und somit den Montagevorgang des Spannmittels nicht behindern können.

An den Aufnahmen ist jeweils zumindest eine Abstützfläche für das Spannmittel vorgesehen, wobei die Abstützflächen auf einander abgewandten Seiten der Aufnahmen vorgesehen sind. Das Spannmittel stützt sich an diesen Abstützflächen ab und drückt diese zum Klemmen der Batteriepolklemme auf einem Batteriepol gegeneinander. Das Spannmittel hat hierzu vorzugsweise jeweils eine Druckfläche, die sich in der jeweiligen Abstützfläche abstützt. Vorzugsweise können die Verdrehsicherung, die Verschiebesicherung und/oder die Verliersicherung im Bereich der Abstandsflächen vorgesehen sein, sodass diese an einem Element, dass die Druckfläche bildet, angreifen können. Beispielsweise ist die Druckfläche an einem Flansch, insbesondere mit einem Drehmomentübertragungsprofil, ausgebildet. Das Drehmomentübertragungsprofil kann zum Eingriff der Verdrehsicherung oder eines Werkzeugs verwendet werden.

Die Aufnahmen sind vorzugsweise bezüglich einer sich durch die Längsachse des Aufnahmeraums erstreckenden Ebene spiegelsymmetrisch ausgebildet. Hierzu ist vorzugsweise bereits der Grundkörper, aus dem die Batteriepolklemme hergestellt wird, bezüglich dieser Ebene spiegelsymmetrisch.

Dies hat den Vorteil, dass das Spannmittel in zwei verschiedenen, bezüglich der Ebene spiegelbildlichen Positionen in den Aufnahmen montiert werden kann. Das Spannmittel kann in Abhängigkeit von der Zugänglichkeit für ein Werkzeug zur Montage der Polklemme am Batteriepol in der Batteriepolklemme eingesetzt werden. Dadurch wird die Flexibilität der Batteriepolklemme erhöht, da für verschiedene Einbausituationen dieselbe Batteriepolklemme verwendet werden kann, wodurch die Anzahl verschiedener Batteriepolklemme, die vorrätig gehalten werden müssen, reduziert werden kann. Bei einer Fahrzeugbatterie sind die Batteriepole jeweils in einer Polnische angeordnet, die jeweils durch eine im wesentlichen quaderförmige Aussparung an eine Ecke der der Fahrzeugbatterie gebildet sind. Üblicherweise sind die Polnischen an benachbarten Ecken ausgebildet. In Abhängigkeit davon, an welcher der Polnischen die Batteriepolklemme montiert werden soll, kann die Richtung, aus der die Batteriepolklemme erreichbar ist, variieren. Aufgrund des spiegelsymmetrischen Aufbaus kann die Batteriepolklemme an beiden Batterie Polen verwendet werden, wobei lediglich die Richtung, in der das Spannmittel eingesetzt wird, angepasst werden muss.

Vorzugsweise sind an beiden Aufnahmen jeweils Abschnitte für die Verdrehsicherung, die Verschiebesicherung und/oder die Verliersicherung vorgesehen, wobei die jeweils benötigten Abschnitte vor und/oder nach der Montage des Spannmittels zu einer Verdrehsicherung, einer Verschiebesicherung und/oder einer Verliersicherung umgeformt werden.

Zur Lösung der Aufgabe ist des Weiteren ein Batteriesensor für eine Batterie vorgesehen, insbesondere in einem Fahrzeug, mit einer Erfassungseinrichtung zur Erfassung eines Batterieparameters und mit einer vorstehend beschriebenen Batteriepolklemme zur Kontaktierung des Batteriesensors mit einem Batteriepol der Batterie.

Weitere Vorteile und Merkmale ergeben sich aus der nachfolgenden Beschreibung in Verbindung mit den beigefügten Zeichnungen. In diesem zeigen:
- Figur 1: eine erste Ansicht der erfindungsgemäßen Batteriepolklemme;
- Figur 2: eine zweite Ansicht der Batteriepolklemme aus Figur 1
- Figur 3: einen ersten Herstellungsschritt der Batteriepolklemme aus den Figuren 1 und 2;
- Figur 4: einen Detailansicht einer zweiten Ausführungsform einer erfindungsgemäßen Batteriepolklemme; und
- Figur 5: einen Detailansicht einer dritten Ausführungsform einer erfindungsgemäßen Batteriepolklemme.

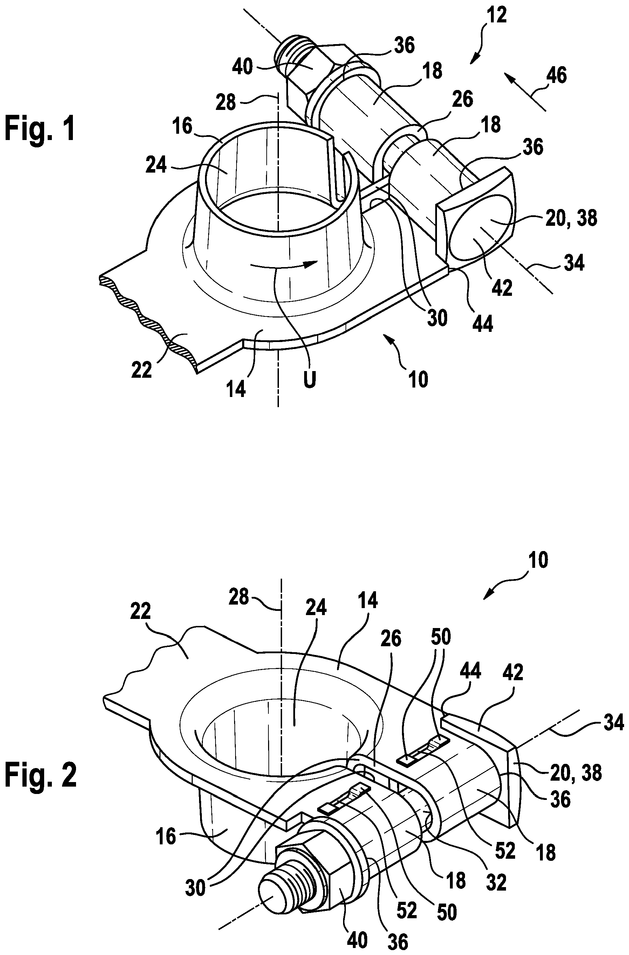

In den Figuren 1 und 2 ist eine Batteriepolklemme 10 eines Batteriesensors 12 gezeigt. Die Batteriepolklemme 10 dient der Montage des Batteriesensors 12 an einem Batteriepol einer Batterie, insbesondere einer Fahrzeugbatterie. Im montierten Zustand des Batteriesensors 12 kann der Batteriesensor 12 Batterieparameter, beispielsweise den Batteriestrom, die Batteriespannung und/oder die Batterietemperatur erfassen. Aus den Batterieparametern können Aussagen über den Batteriezustand, beispielsweise den Ladezustand der Batterie, getroffen werden.

Die Batteriepolklemme 10 weist einen Grundkörper 14 auf, an dem ein Klemmabschnitt 16 für einen Batteriepol sowie zwei Aufnahmen 18 für ein Spannmittel 20 vorgesehen sind. Des Weiteren weist der Grundkörper 14 einen Leitungsabschnitt 22 auf, an dem zumindest eine Erfassungseinrichtung für zumindest einen Batterieparameter vorgesehen sein kann.

Der Klemmabschnitt 16 umschließt einen im Wesentlichen zylindrischen Aufnahmeraum 24 für den Batteriepol. In Umfangsrichtung U weist der Klemmabschnitt 16 eine Unterbrechung 26 auf. Die Unterbrechung 26 wird durch einen bezüglich der Längsachse 28 des zylindrischen Aufnahmeraum 24 radial verlaufenden Schlitz gebildet, der von zwei einander zugewandten Rändern 30 begrenzt wird.

An den Rändern 30 ist jeweils eine der Aufnahmen 18 vorgesehen, wobei die Aufnahmen jeweils einen Kanal 32 zur Aufnahme des Spannmittels 20 aufweisen. Die Kanäle 32 sind im Wesentlichen zylindrisch ausgebildet, wobei die Längsachsen der Kanäle 32 im Wesentlichen auf einer gemeinsamen Geraden 34 verlaufen. Die Aufnahmen 18 weisen des Weiteren jeweils eine Abstützfläche 36 für das Spannmittel 20 auf. Die Abstützflächen 36 sind jeweils von den Rändern 30 abgewandt und auf voneinander abgewandten Flächen der Aufnahmen 18 vorgesehen.

Das Spannmittel 20 ist in der hier gezeigten Ausführungsform durch eine Schraube 38 mit einem Außengewinde sowie eine Mutter 40 mit einem zum Außengewinde korrespondierenden Innengewinde gebildet. Die Schraube 38 stützt sich mit einem Flansch 42 an einer ersten Abstützfläche 30 ab. Die Mutter 40 stützt sich an der zweiten, von der ersten Abstützfläche 36 abgewandten Abstützfläche 36 ab. Wird die Mutter 40 auf die Schraube 38 so aufgedreht, dass sich der Abstand von der Mutter 40 zum Flansch 42 verkürzt, werden durch das Spannmittel 20 die Abstützflächen 30 und somit die Aufnahmen 18 aufeinander zu gedrängt. Die Unterbrechung 26 wird dadurch verkleinert, sodass der Durchmesser des Aufnahmeraums 24 reduziert wird. Ist die Batteriepolklemme 10 auf einen Batteriepol aufgesetzt, wird der Klemmabschnitt 16 auf dem Batteriepol verklemmt.

Zur Montage der Batteriepolklemme 10 wird die Batteriepolklemme 10 mit dem Aufnahmeraum 24 auf einen Batteriepol aufgeschoben. Anschließend werden durch das Spannmittel 20 die Aufnahmen 18 aufeinander zu gedrängt, also die Unterbrechung 26 verkleinert und somit der Durchmesser des Aufnahmeraums 24 reduziert. Liegt der Batteriepol flächig an der Innenwandung des Aufnahmeraums 24 an, erfolgt durch ein weiteres Anziehen des Spannmittels 20 ein Verklemmen der Batteriepolklemme 10 auf dem Batteriepol.

Zum Lösen der Batteriepolklemme 10 wird das Spannmittel 20 entspannt, sodass sich die Aufnahmen 18 voneinander weg bewegen können, wodurch die Unterbrechung 26 und der Durchmesser des Aufnahmeraums 24 vergrößert werden.

Wie in den Figuren 1 und 2 zu sehen ist, ist der Flansch 42 quadratisch und bildet ein Drehmomentübertragungsprofil. Am Grundkörper 14 ist eine Verdrehsicherung 44 vorgesehen, die durch einen Vorsprung des Grundkörpers 14 gebildet ist. Wird die Mutter 40 gedreht, kann sich die Schraube 38 nicht mit der Mutter 40 mit drehen, sodass die Mutter 40 auf die Schraube 38 aufgedreht oder von dieser abgedreht wird. Somit ist zum Öffnen und Schließen der Batteriepolklemme 10 nur ein Drehen der Mutter 40 erforderlich. Das heißt, es ist nur ein Werkzeug erforderlich, nämlich ein Werkzeug zum Drehen der Mutter 40.

Wie des Weiteren in den Figuren 1 und 2 zu sehen ist, sind die Aufnahmen 18 bezüglich einer durch die Unterbrechung 26 verlaufenden, die Längsachse 38 des Aufnahmeraums 24 einschließenden Ebene spiegelsymmetrisch ausgebildet. Die Gerade 34 verläuft also bezüglich der Symmetrieebene im Wesentlichen senkrecht. Des Weiteren weisen die Ränder 30 sowie die Abstützflächen 36 im Wesentlichen jeweils im Wesentlichen den gleichen Abstand zur Symmetrieebene auf. Zudem ist an beiden Aufnahmen 18 jeweils eine Verdrehsicherung 44 vorgesehen. Durch den symmetrischen Aufbau kann die Schraube 38 in einer ersten, in den Figuren 1 und 2 gezeigten Montagerichtung 46 sowie in einer zweiten, entgegengesetzten Montagerichtung in die Aufnahmen 18 eingeschoben werden. Die Montagerichtung kann in Abhängigkeit von den Einbaubedingungen gewählt werden. Insbesondere ist ein Wechsel der Montagerichtung möglich, falls dies erforderlich sein sollte.

Die Gerade 34 verläuft in der hier gezeigten Ausführungsform in einer senkrecht zur Längsachse 28 des Aufnahmeraums 24 angeordneten Ebene sowie senkrecht zur Längsachse 28. In Abhängigkeit von den Abmessungen der Batteriepolklemme 10 sowie den gewünschten Klemmkräften ist aber auch eine andere Ausrichtung der Geraden 34 möglich.

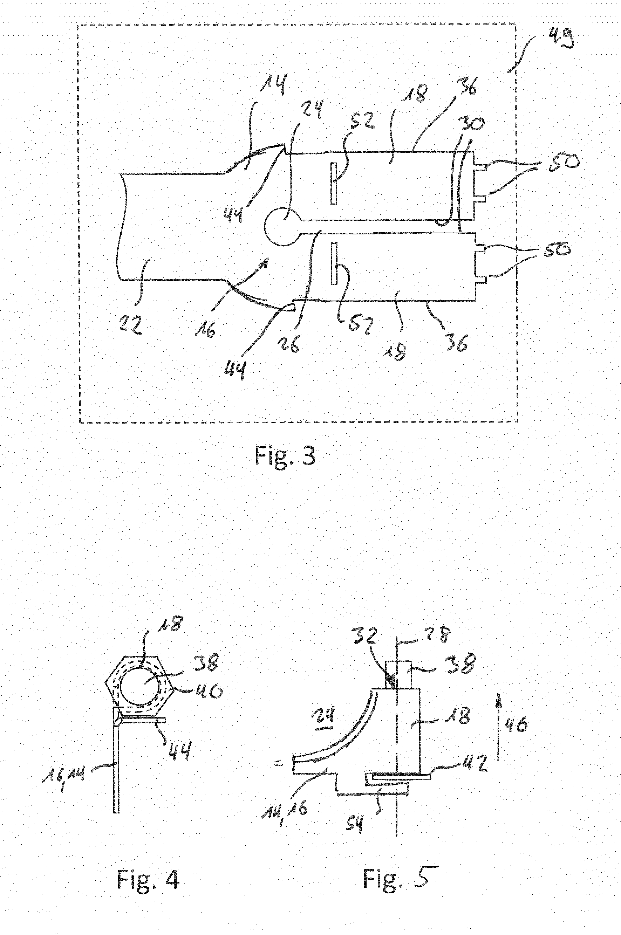

Die gesamte Batteriepolklemme 10 ist einstückig, d. h. aus einem ebenen Blechteil 49 (Figur 4), hergestellt. In einem ersten Verfahrensschritt wird aus dem ebenen Blechteil 49 der Grundkörper 14 geformt, beispielsweise ausgestanzt. Bei der Bereitstellung des Grundkörpers können bereits die Unterbrechung 26 sowie weitere Aussparungen, beispielsweise für den Aufnahmeraum 24, ausgebildet werden.

Anschließend wird der Klemmabschnitt 16 durch ein Tiefzugverfahren hergestellt. Hierzu wird der Grundkörper 14 in eine Pressform eingelegt und der Klemmabschnitt 16 durch einen Prägestempel, der gegen den Grundkörper 14 bewegt wird, ausgeformt.

Nach dem Ausformen des Klemmabschnitts 16 werden die Aufnahmen 18 durch Umformen von Abschnitten 48 des Grundkörpers 14 ausgebildet. Die Abschnitten 48 werden hierbei so weit umgebogen, bis sich an den Abschnitten 48 vorgesehene Vorsprünge 50 in Aussparungen 52 am Grundkörper hinein erstrecken, sodass die Aufnahmen bezüglich der Geraden 34 in Umfangsrichtung geschlossen sind. Anschließend werden die jeweils zwei Vorsprünge 50 in der Aussparungen 52 verstemmt, sodass eine formschlüssige Verbindung zwischen den Vorsprüngen 50 und den Aussparungen 52 hergestellt (siehe auch Figur 2).

Anschließend wird das Spannmittel 20 in die Aufnahmen 18 eingesetzt.

In der in den Figuren 1 und 2 gezeigten Ausführungsform ist die Verdrehsicherung 44 durch einen Absatz im Grundkörper 14 gebildet. Alternativ kann die Verdrehsicherung 44 auch durch einen Abschnitt des Grundkörpers gebildet sein, der vor oder nach dem Einsetzen des Spannmittels 20 so umgeformt wird, dass dieser ein Verdrehen des Spannmittels 20 verhindert (Figur 4). Die Verdrehsicherung 44 kann auch an der Mutter 40 angreifen.

Optional kann durch einen Abschnitt des Grundkörpers 14 auch eine Verliersicherung gebildet werden, die das Spannmittel 20, insbesondere die Schraube 38 und oder die Mutter 40 in den Aufnahmen 18 fixiert, sodass diese, beispielsweise beim Transport, nicht verloren gehen können. Vorzugsweise wird die Verliersicherung nach der Montage des Spannmittels 20 umgeformt, sodass das Spannmittel 20 zuverlässig in den Aufnahmen 18 fixiert ist.

Zusätzlich kann am Grundkörper 14 eine Verschiebesicherung 54 für das Spannmittel 20 vorgesehen sein, die ein Verschieben des Spannmittels 20 in Richtung der Geraden 34 verhindert (Figur 5). Die Verschiebesicherung 54 kann beispielsweise auch eine Verliersicherung bilden. Zusätzlich werden, wenn das Spannmittel 20 entlastet wird, also in der in den Figuren 1 und 2 gezeigten Ausführungsform die Schraube 38 und die Mutter 40 auseinander geschraubt werden, die Aufnahmen 18 auseinander bewegt, da diese in Richtung der Geraden 34 mit der Schraube 38 und der Mutter 40 formschlüssig verbunden sind. Dadurch wird die Unterbrechung 26 verbreitert und somit der Aufnahmeraum 24 vergrößert. Bei einem Entspannen des Spannmittels 20 erfolgt somit gewissermaßen eine Zwangsöffnung der Batteriepolklemme 10, sodass ein einfaches Abnehmen der Batteriepolklemme 10 vom Batteriepol möglich ist, da der Klemmabschnitt 16 nicht mehr auf dem Batteriepol verklemmt ist.

Unabhängig von Ausführungsform wird die Batteriepolklemme 10 aus einem ebenen Blechteil bzw. aus einem ebenen Grundkörper 14 hergestellt, wobei der Klemmabschnitt 16 in einem Tiefzugverfahren und die Aufnahmen 18 in einem Uniformverfahren hergestellt werden. Somit ist eine einfache Herstellung der Batteriepolklemme ohne zusätzliche Fügeprozesse möglich.

## Patentansprüche

1. Verfahren zur Herstellung einer Batteriepolklemme (10), insbesondere für eine Fahrzeugbatterie in einem Fahrzeug, wobei die Batteriepolklemme (10) einen Grundkörper (14) aufweist, mit einem Klemmabschnitt (16) für einen Batteriepol einer Batterie, insbesondere einer Fahrzeugbatterie, und am Klemmabschnitt (16) vorgesehenen Aufnahmen (18) für ein Spannmittel (20), wobei der Klemmabschnitt (16) einen, insbesondere im Wesentlichen zylindrischen, Aufnahmeraum (24) für den Batteriepol der Batterie in Umfangsrichtung (U) zumindest abschnittsweise umschließt und in Umfangsrichtung (U) eine Unterbrechung (26) mit einander zugewandten Rändern (30) aufweist, und wobei an den Rändern (30) des Klemmabschnitts (16) jeweils eine Aufnahme (18) für das Spannmittel (20) vorgesehen, mit folgenden Schritten:
- Bereitstellen eines ebenen Grundkörpers (14),
- Ausformen des Klemmabschnitts (16) durch ein Tiefzugverfahren, und
- Ausformen der Aufnahmen (18) durch einen Umformprozess, **dadurch gekennzeichnet dass**, die Aufnahmen (18) jeweils durch Umbiegen eines Abschnitts (48) des Grundkörpers (14) und anschließendes Verstemmen eines am Abschnitt (48) vorgesehenen Vorsprungs (50) in einer Aussparung (52) des Grundkörpers (14) hergestellt werden, so dass die Aufnahmen (18) jeweils einen Kanal (32) für das Spannmittel (20) bilden, der in einer Umfangsrichtung geschlossen ist, wobei die Längsachsen der Kanäle (32) der Aufnahmen (18) auf einer gemeinsamen Geraden (34) liegen.

2. Verfahren nach Anspruch 1, **dadurch gekennzeichnet, dass** an zumindest einer Aufnahme (18) eine Verdrehsicherung (44), eine Verschiebesicherung (54) und/oder eine Verliersicherung für das Spannmittel (20) durch einen Umformprozess hergestellt wird.

3. Verfahren nach Anspruch 2, **dadurch gekennzeichnet, dass** vor dem Ausbilden einer Verdrehsicherung (44), einer Verschiebesicherung (54) und/oder einer Verliersicherung ein Spannmittel (20) in die Aufnahmen (18) eingesetzt wird.

4. Batteriepolklemme (10), insbesondere für eine Fahrzeugbatterie in einem Fahrzeug, wobei die Batteriepolklemme (10) einen Grundkörper (14) aufweist, mit einem Klemmabschnitt (16) für einen Batteriepol einer Batterie, insbesondere einer Fahrzeugbatterie, und am Klemmabschnitt (16) vorgesehenen Aufnahmen (18) für ein Spannmittel (20), wobei der Klemmabschnitt (16) einen, insbesondere im Wesentlichen zylindrischen, Aufnahmeraum (24) für den Batteriepol der Batterie in Umfangsrichtung zumindest abschnittsweise umschließt und in Umfangsrichtung (U) eine Unterbrechung (26) mit einander zugewandten Rändern (30) aufweist, und wobei an den Rändern (30) des Klemmabschnitts (16) jeweils eine Aufnahme (18) für das Spannmittel (20) vorgesehen ist, wobei der Grundkörper (14) einstückig ausgebildet ist, wobei der Klemmabschnitt (16) mit einem Tiefzugverfahren aus dem Grundkörper (14) hergestellt ist und die Aufnahmen (18) durch Umformen des Grundkörpers (14) hergestellt sind **dadurch gekennzeichnet, dass** die Aufnahmen (18) jeweils einen Kanal aufweisen, der durch Umbiegen eines Abschnitts (48) des Grundkörpers (14) und anschließendes Verstemmen eines am Abschnitt (48) vorgesehenen Vorsprungs (50) in einer Aussparung (52) des Grundkörpers (14) hergestellt sind, so dass die Aufnahmen (18) jeweils einen in Umfangsrichtung geschlossenen Kanal (32) für das Spannmittel (20) bilden, wobei die Längsachsen der Kanäle (32) der Aufnahmen (18) auf einer gemeinsamen Geraden (34) liegen.

5. Batteriepolklemme nach Anspruch 4, **dadurch gekennzeichnet, dass** beide Aufnahme (18) jeweils durch einen Kanal gebildet sind, wobei die Längsachsen der Kanäle senkrecht zur Längsachse des Aufnahmeraums (24) und auf einer gemeinsamen Geraden (34) verlaufen.

6. Batteriepolklemme nach einem der Ansprüche 4 bis 5, **dadurch gekennzeichnet, dass** an zumindest einer Aufnahme (18) eine Verdrehsicherung (44) für das Spannmittel (20) vorgesehen ist, wobei die Verdrehsicherung (44) eine Drehung des Spannmittels um die Längsachse der Aufnahme (18) verhindert, wobei die Verdrehsicherung (44) insbesondere durch einen Umformprozess hergestellt ist.

7. Batteriepolklemme nach einem der Ansprüche 4 bis 6, **dadurch gekennzeichnet, dass** an zumindest eine Aufnahme (18) eine Verschiebesicherung (54) für das Spannmittel (20) vorgesehen ist, dass ein Verschieben des Spannmittels (20) in Richtung der Längsachse verhindert, wobei die Verschiebesicherung (54) insbesondere durch einen Umformprozess hergestellt ist.

8. Batteriepolklemme nach einem der Ansprüche 4 bis 6, **dadurch gekennzeichnet, dass** an zumindest einer Aufnahme (18) eine Verliersicherung (54) vorgesehen ist, die das Spannmittel (20) an der Aufnahme (18) fixiert, wobei die Verlierersicherung (54) insbesondere durch einen Umformprozess hergestellt ist.

9. Batteriepolklemme nach einem der Ansprüche 4 bis 8, **dadurch gekennzeichnet, dass** an den Aufnahmen (18) jeweils zumindest eine Abstützfläche (36) für das Spannmittel (20) vorgesehen ist, wobei die Abstützflächen (36) auf einander abgewandten Seiten der Aufnahmen (18) vorgesehen sind.

10. Batteriepolklemme nach einem der Ansprüche 4 bis 9, **dadurch gekennzeichnet, dass** die Aufnahmen (18) bezüglich einer sich durch die Längsachse (28) des Aufnahmeraums (24) erstreckenden Ebene spiegelsymmetrisch ausgebildet sind.

11. Batteriesensor (12) für eine Batterie, insbesondere in einem Fahrzeug, mit einer Erfassungseinrichtung zur Erfassung eines Batterieparameters und mit einer Batteriepolklemme (10) nach einem der Ansprüche 4 bis 9 zur Kontaktierung des Batteriesensors (12) mit einem Pol einer Batterie.

## Claims

1. Method for producing a battery pole terminal (10), in particular for a vehicle battery in a vehicle, the battery pole terminal (10) having a main body (14) with a clamping section (16) for a battery pole of a battery, in particular a vehicle battery, and receptacles (18), which are provided on the clamping section (16), for a clamping means (20), the clamping section (16) enclosing an, in particular substantially cylindrical, receiving space (24) for the battery pole of the battery at least in sections in the circumferential direction (U) and having an interruption (26) with mutually facing edges (30) in the circumferential direction (U), and a receptacle (18) for the clamping means (20) being provided at each of the edges (30) of the clamping section (16), comprising the following steps:
- providing a flat main body (14),
- forming the clamping section (16) by way of a deep-drawing process, and
- forming the receptacles (18) by way of a shaping process,
**characterized in that** the receptacles (18) are each produced by bending over a section (48) of the main body (14) and then caulking a projection (50), which is provided on the section (48), in a cutout (52) in the main body (14), so that the receptacles (18) each form a channel (32) for the clamping means (20), which channel is closed in a circumferential direction, the longitudinal axes of the channels (32) of the receptacles (18) lying on a common straight line (34).

2. Method according to Claim 1, **characterized in that** a rotation-prevention device (44), a displacement-prevention device (54) and/or a captive-retention device for the clamping means (20) are/is produced by a shaping process on at least one receptacle (18).

3. Method according to Claim 2, **characterized in that** a clamping means (20) is inserted into the receptacles (18) before a rotation-prevention device (44), a displacement-prevention device (54) and/or a captive-retention device are/is formed.

4. Battery pole terminal (10), in particular for a vehicle battery in a vehicle, the battery pole terminal (10) having a main body (14) with a clamping section (16) for a battery pole of a battery, in particular a vehicle battery, and receptacles (18), which are provided on the clamping section (16), for a clamping means (20), the clamping section (16) enclosing an, in particular substantially cylindrical, receiving space (24) for the battery pole of the battery at least in sections in the circumferential direction and having an interruption (26) with mutually facing edges (30) in the circumferential direction (U), and a receptacle (18) for the clamping means (20) being provided at each of the edges (30) of the clamping section (16), the main body (14) being formed in one piece, the clamping section (16) being produced from the main body (14) by way of a deep-drawing process and the receptacles (18) being produced by shaping the main body (14), **characterized in that** the receptacles (18) each have a channel, which channels are produced by bending over a section (48) of the main body (14) and then caulking a projection (50), which is provided on the section (48), in a cutout (52) in the main body (14), so that the receptacles (18) each form a channel (32) for the clamping means (20), which channel is closed in a circumferential direction, the longitudinal axes of the channels (32) of the receptacles (18) lying on a common straight line (34).

5. Battery pole terminal according to Claim 4, **characterized in that** the two receptacles (18) are each formed by a channel, the longitudinal axes of the channels running perpendicularly to the longitudinal axis of the receiving space (24) and on a common straight line (34).

6. Battery pole terminal according to either of Claims 4 and 5, **characterized in that** a rotation-prevention device (44) for the clamping means (20) is provided on at least one receptacle (18), the rotation-prevention device (44) preventing rotation of the clamping means about the longitudinal axis of the receptacle (18) and the rotation-prevention device (44) being produced, in particular, by way of a shaping process.

7. Battery pole terminal according to one of Claims 4 to 6, **characterized in that** a displacement-prevention device (54) for the clamping means (20), which displacement-prevention device prevents displacement of the clamping means (20) in the direction of the longitudinal axis, is provided on at least one receptacle (18), the displacement-prevention device (54) being produced, in particular, by way of a shaping process.

8. Battery pole terminal according to one of Claims 4 to 6, **characterized in that** a captive-retention device (54), which secures the clamping means (20) on the receptacle (18), is provided on at least one receptacle (18), the captive-retention device (54) being produced, in particular, by way of a shaping process.

9. Battery pole terminal according to one of Claims 4 to 8, **characterized in that** at least one supporting surface (36) for the clamping means (20) is provided on each of the receptacles (18), the supporting surfaces (36) being provided on mutually averted sides of the receptacles (18).

10. Battery pole terminal according to one of Claims 4 to 9, **characterized in that** the receptacles (18) are designed with mirror-image symmetry with respect to a plane extending through the longitudinal axis (28) of the receiving space (24).

11. Battery sensor (12) for a battery, particular in a vehicle, having a detection device for detecting a battery parameter and having a battery pole terminal (10) according to one of Claims 4 to 9 for contact-connecting the battery sensor (12) to a pole of a battery.

## Revendications

1. Procédé de fabrication d'une pince de borne de batterie (10), destinée notamment à une batterie de véhicule dans un véhicule, la pince de borne de batterie (10) comportant un corps de base (14), une portion de pince (16) étant destinée à une borne d'une batterie, en particulier d'une batterie de véhicule, et des logements (18) prévus sur la portion de pince (16) étant destinés à un moyen de serrage (20), la portion de pince (16) entourant au moins par portions dans la direction circonférentielle (U) un espace de réception (24), en particulier sensiblement cylindrique, destiné à la borne de la batterie et comportant une interruption (26), pourvue de bords (30) dirigés les uns vers les autres, dans la direction circonférentielle (U), et un logement (18) destiné au moyen de serrage (20) étant prévu sur chacun des bords (30) de la portion de pince (16), ledit procédé comprenant les étapes suivantes :
- fournir un corps de base plan (14),
- former la portion de pince (16) par un procédé d'emboutissage profond, et
- former les logements (18) par un processus de formage, **caractérisé en ce que**
les logements (18) sont chacun réalisés par cintrage d'une portion (48) du corps de base (14) puis par matage d'une saillie (50), prévue sur la portion (48), dans un évidement (52) du corps de base (14) de sorte que les logements (18) forment chacun un conduit (32) qui est destiné au moyen de serrage (20) et qui est fermé dans une direction circonférentielle, les axes longitudinaux des conduits (32) des logements (18) étant situés sur une ligne droite commune (34).

2. Procédé selon la revendication 1, **caractérisé en ce qu'**une sécurité anti-rotation (44), une sécurité anti-translation (54) et/ou une sécurité anti-perte destinées au moyen de serrage (20) sont réalisées par un processus de formage au niveau d'au moins un logement (18).

3. Procédé selon la revendication 2, **caractérisé en ce qu'**un moyen de serrage (20) est inséré dans les logements (18) avant de former une sécurité anti-rotation (44), une sécurité anti-translation (54) et/ou une sécurité anti-perte.

4. Pince de borne de batterie (10), destinée notamment à une batterie de véhicule dans un véhicule, la pince de borne de batterie (10) comportant un corps de base (14), une portion de pince (16) étant destinée à une borne d'une batterie, en particulier d'une batterie de véhicule, et des logements (18) prévus sur la portion de pince (16) étant destinés à un moyen de serrage (20), la portion de pince (16) entourant au moins par portions dans la direction circonférentielle (U) un espace de réception (24), en particulier sensiblement cylindrique, destiné à la borne de la batterie et comportant une interruption (26), pourvue de bords (30) dirigés les uns vers les autres, dans la direction circonférentielle (U), et un logement (18) destiné au moyen de serrage (20) étant prévu sur chacun des bords (30) de la portion de pince (16), le corps de base (14) étant formé d'une seule pièce ,
la portion de serrage (16) étant fabriquée à partir du corps de base (14) par un procédé d'emboutissage profond et les logements (18) étant réalisés par formage du corps de base (14), **caractérisée en ce que** les logements (18) comportent chacun un conduit qui est réalisé par cintrage d'une portion (48) du corps de base (14) et ensuite par matage d'une saillie (50), prévue sur la portion (48), dans un évidement (52) du corps de base (14) de sorte que les logements (18) forment chacun un conduit fermé dans la direction circonférentielle (32) et destiné au moyen de serrage (20), les axes longitudinaux des conduits (32) des logements (18) étant situés sur une ligne droite commune (34).

5. Pince de borne de batterie selon la revendication 4, **caractérisée en ce que** les deux logements (18) sont formés chacun par un conduit, les axes longitudinaux des conduits s'étendant perpendiculairement à l'axe longitudinal de l'espace de réception (24) et sur une ligne droite commune (34).

6. Pince de borne de batterie selon l'une des revendications 4 à 5, **caractérisée en ce qu'**une sécurité anti-rotation (44) destinée au moyen de serrage (20) est prévue au niveau d'au moins un logement (18), la sécurité anti-rotation (44) empêchant le moyen de serrage de tourner sur l'axe longitudinal du logement (18), la sécurité anti-rotation (44) étant réalisée notamment par un processus de formage.

7. Pince de borne de batterie selon l'une des revendications 4 à 6, **caractérisée en ce qu'**une sécurité anti-translation (54) destinée au moyen de serrage (20) est prévue au niveau d'au moins un logement (18) de sorte que la translation du moyen de serrage (20) est empêchée dans la direction de l'axe longitudinal, la sécurité anti-translation (54) étant réalisée notamment par un processus de formage.

8. Pince de borne de batterie selon l'une des revendications 4 à 6, **caractérisée en ce qu'**une sécurité anti-perte (54) est prévue au niveau d'au moins un logement (18), laquelle fixe le moyen de serrage (20) au logement (18), la sécurité anti-perte (54) étant réalisée notamment par un processus de formage.

9. Pince de borne de batterie selon l'une des revendications 4 à 8, **caractérisée en ce qu'**au moins une surface d'appui (36) destinée au moyen de serrage (20) est prévue au niveau de chacun des logements (18), les surfaces d'appui (36) étant prévues sur des côtés opposés des logements (18).

10. Pince de borne de batterie selon l'une des revendications 4 à 9, **caractérisée en ce que** les logements (18) sont conçus pour être à symétrie de miroir par rapport à un plan qui passe par l'axe longitudinal (28) de l'espace de réception (24).

11. Capteur de batterie (12) destiné à une batterie, en particulier dans un véhicule, et comprenant un module de détection destiné à détecter un paramètre de batterie et une pince de borne de batterie (10) selon l'une des revendications 4 à 9 destinée à mettre le capteur de batterie (12) en contact avec une borne d'une batterie.
